# EUROPÄISCHE PATENTSCHRIFT

(11) **EP 0 489 035 B1**
(45) Veröffentlichungstag und Bekanntmachung des Hinweises auf die Patenterteilung: **02.11.1994**
(21) Anmeldenummer: 90911613.9
(22) Anmeldetag: 16.07.1990
(51) Int. Cl.: H03M 13/00

(54) **VERFAHREN ZUR ERZEUGUNG VON PARITÄTSSYMBOLEN UND SCHALTUNGSANORDNUNG ZUR DURCHFÜHRUNG DES VERFAHRENS**
PROCESS AND CIRCUIT FOR PRODUCING PARITY SYMBOLS
PROCEDE ET CIRCUIT POUR PRODUIRE DES SYMBOLES DE PARITE

(30) Priorität: 21.08.1989 DE 3927527
(43) Veröffentlichungstag der Anmeldung: 10.06.1992
(73) Patentinhaber: Deutsche Thomson-Brandt GmbH, 78003 Villingen-Schwenningen (DE)
(72) Erfinder: SCHEMMANN, Heinrich, D-7730 Villingen-Schwenningen (DE)
(86) Internationale Anmeldenummer: EP9001164
(87) Internationale Veröffentlichungsnummer: WO9103106

(56) Entgegenhaltungen:
- US-A- 3 638 182
- US-A- 3 668 632
- US-A- 4 160 236
- US-A- 4 777 635

## Beschreibung

Die Erfindung betrifft ein Verfahren zur Erzeugung von Paritätssymbolen für Datenworte aus mindestens zwei Bits und eine Schaltungsanordnung zur Durchführung des Verfahrens.

In einem Codierer für den Reed-Solomon-Code, einem sogenannten Reed-Solomon-Codierer, werden Paritätssymbole, die an die Datenworte angefügt werden, in einem rückgekoppelten Schieberegister erzeugt. Reed Solomon Codierer dienen z.B. zum Codieren von Audiosignalen, die nach dem gebräuchlichen CD-Standard auf eine CD-Platte aufgezeichnet werden.

Weil CD-Platten aber mit verschiedenen physikalischen Fehlern behaftet sein können, die sich bei der Produktion der Platten nie mit Sicherheit vermeiden lassen, werden die aufzuzeichnenden Audiosignale nach einem speziellen Codierverfahren codiert.

Aus den digitalen Audiosignalen, die nach dem Pulscodemodulationsverfahren moduliert sind, wird ein serieller Datenstrom mittels eines Reed Solomon Codierers im Eight-To-Fourteen Modulation Code, kurz EFM-Code genannt, erzeugt, weil dieser Code gegenüber den auf der CD-Platte möglicherweise vorhandenen physikalischen Fehlern relativ unempfindlich ist. Mit anderen Worten ausgedrückt heißt dies, daß die Fehler auf den CD-Platten die Audiosignale infolge ihrer speziellen Codierung nicht verfälschen können. Dem CD-Liebhaber bietet ein CD-Spieler daher trotz fehlerhafter Platte eine ausgezeichnete Tonwiedergabe.

Die Codierung der digitalen Audiosignale erfolgt nach der sogenannten Cross Interleave Reed Solomon Codierung mittels zweier hintereinander geschalteter Reed Solomon Codierer.

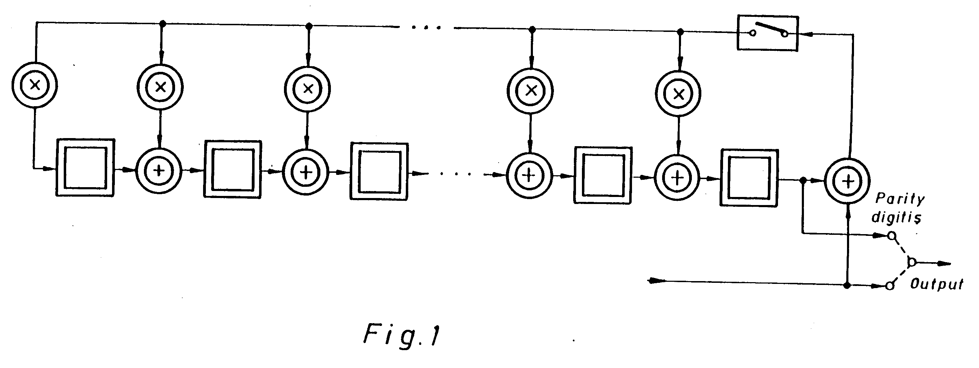

Weil beim Aufzeichnen der Audiosignale auf eine CD-Platte keine hohe Arbeitsgeschwindigket erforderlich ist, lassen sich die beiden Codiervorgänge anstatt mittels zweier Codierer auch nacheinander in nur einem Codierer durchführen. Aus Lin, Costello: Error Control Coding-Fundamentals and Applications, Prentice-Hall, New Jersey, 1983 ist ein Reed Solomon Codierer bekannt, der in Figur 1 gezeigt ist.

Dieser Reed-Solomon-Codierer enthält ein rückgekoppeltes Schieberegister mit n - k Stufen, zwischen denen je ein Addierer liegt. Der Ausgang der letzten Stufe ist mit dem ersten Eingang eines Addierers verbunden, an dessen zweitem Eingang das zu codierende Eingangssignal liegt. Der Ausgang dieses Addierers ist über einen Schalter mit dem Eingang von n - k Multiplizierern verbunden, die in den einzelnen Rückführungsleitungen vorgesehen sind, um für jede Stufe eine Gewichtung des rückgekoppelten Signals mit vorgegebenen Koeffizienten durchzuführen.

Zur Erzeugung der Paritätssymbole werden die Datenworte nacheinander in das rückgekoppelte Schieberegister geschrieben. Anschließend wird der Schalter geöffnet, so daß die Rückkopplung unterbrochen wird. Jetzt werden die im Schieberegister durch die Gewichtung gebildeten n - k Paritätssymbole aus dem Schieberegister geschoben und an die ursprünglichen k Datenworte angehängt, so daß insgesamt n - k + k = n neue Datenworte, gebildet werden, die sich aus den ursprünglichen k Datenworten und den n -k Paritätssymbolen zusammensetzen. Damit ist der erste Codiervorgang, die sogenannte C1-Codierung, abgeschlossen.

In einem anderen Reed Solomon Codierer, der vier Paritätssymbole erzeugt und in der Mitte der Datenworte einfügt, wird der zweite Codierschritt, die sogenannte C2-Codierung, durchgeführt.

Des weiteren sind aus US-A-4 777 635 Schaltungsanordnungen zur Reed Solomon Codierung bekannt, in welchen Datenworte aus mindestens zwei Bits in einem sogenannten Interleave Modus überlappend verarbeitet werden.

Aufgabe der Erfindung ist es deshalb, ein Verfahren zur Erzeugung von Paritätssymbolen für digitale Datenworte sowohl nach einem ersten als auch nach einem zweiten Codierverfahren so zu gestalten, daß der Schaltungsaufwand verringert wird.

Die Erfindung löst diese Aufgabe durch folgenden Merkmale:
a) es werden k erste Datenworte in ein rückgekoppeltes Schieberegister geschoben
b) das rückgekoppelte Schieberegister erzeugt aus den k ersten Datenworten ebenso viele Paritätssymbole wie es Stufen hat, wobei jedes Paritätssymbol ebenso viele Bits hat wie ein Datenwort
c) die vom rückgekoppelten Schieberegister erzeugten Paritätssymbole werden in ein Speicherschieberegister geschoben.
d) in das rückgekoppelte Schieberegister werden k zweite Datenworte geschoben
e) das rückgekoppelte Schieberegister erzeugt aus den k zweiten Datenworten ebenso viele Paritätssymbole wie es Stufen hat, wobei jedes Paritätssymbol aus ebensovielen Bits wie ein Datenwort besteht
f) zum Auslesen der im Speicherschieberegister stehenden Paritätssymbole wird die Richtung des Datenflußes im Speicherschieberegister umgekehrt
g) die im rückgekoppelten Schieberegister und im Speicherschieberegister stehenden Paritätssymbole werden ausgelesen und den Eingängen eines Addierers zugeführt
h) der Addierer erzeugt für die insgesamt zwei k Datenworte aus den vom Speicherschieberegister und vom rückgekoppelten Schieberegister gelieferten Paritätssymbolen ebenso viele neue Paritätssymbole wie ein Schieberegister Stufen hat, wobei jedes Paritätssymbol aus ebensovielen Bits wie ein Datenwort besteht.

Es zeigen
- Figur 1: ein rückgekoppeltes Schieberegister mit Multiplizierern und Addierern
- Figur 2: eine Schaltungsanordnung mit einem rückgekoppelten Schieberegister und einem Speicherschieberegister zur Durchführung des erfindungsgemäßen Verfahrens.

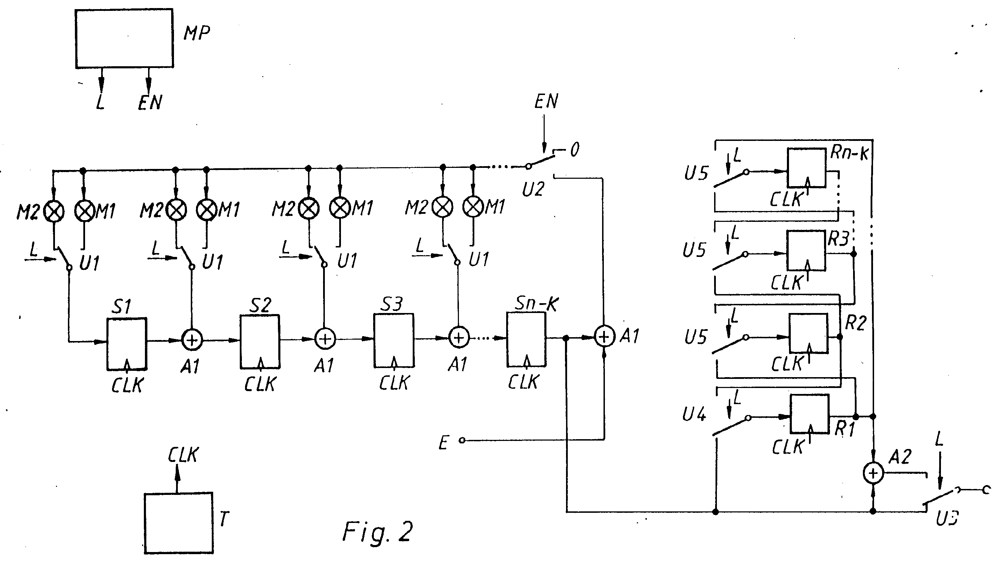

Anhand der Figur 2 wird die Erfindung nun beschrieben und erläutert.

Das zu codierende Eingangssignal E - eine Folge von jeweils k Datenworten - wird dem Eingang eines rückgekoppelten Schieberegisters zugeführt. Zwischen den einzelnen n - k Stufen S1 bis Sn-k des rückgekoppelten Schieberegisters ist je ein Addierer A1 vorgesehen. In den Rückkopplungszweigen, die zu den Addierern A1 führen, sowie in dem Rückkopplungszweig, der zum Eingang der ersten Stufe S1 führt, liegen jeweils zwei Multiplizierer M1 und M2 zueinander parallel; mittels eines steuerbaren Umschalters U1 wird in jedem Rückkopplungszweig entweder der eine oder der andere Multiplizierer mit dem Addierer bzw. mit dem Eingang der ersten Stufe verbunden. Der Ausgang der letzten Stufe Sn ist mit dem Eingang eines Speicherschieberegisters, mit dem ersten Eingang eines Addierers A2 und mit dem ersten Eingang eines steuerbaren Umschalters U3 und U4 verbunden.

Beim Speicherschieberegister sind ebenfalls n - k Register R1 bis Rn-k derart hintereinandergeschaltet, daß der Eingang jedes Registers R2 bis Rn-k mit Ausnahme des ersten Registers R1 mittels eines steuerbaren Umschalters U5 entweder mit dem Ausgang des vorhergehenden oder des folgenden Registers verbunden werden kann, so daß die Datenworte entweder in der einen oder in der anderen Richtung durch das Speicherschieberegister geschoben werden können. Der Eingang des ersten Registers R1 wird mittels des steuerbaren Umschalters U4 entweder mit dem Ausgang des zweiten Registers R2 oder mit dem Ausgang der letzten Stufe Sn des rückgekoppelten Schieberegisters verbunden. Der Ausgang des ersten Registers R1 ist mit dem zweiten Eingang des Addierers A2 verbunden, dessen Ausgang mit dem zweiten Eingang des steuerbaren Umschalters U3 verbunden ist.

Die Erzeugung der Paritätssymbole für die C1-Codierung erfolgt im rückgekoppelten Schieberegister in der zuvor beschriebenen bekannten Weise. Hierzu wird das Speicherschieberegister nicht benötigt. In den Stufen S1 - Sn-k des rückgekoppelten Schieberegisters stehen zu Beginn lauter binäre Nullen. Es werden nun k Datenworte mit dem Takt CLK, den ein Taktgenerator T erzeugt, in das rückgekoppelte Schieberegister eingeschoben. Während dieses Vorgangs schließt der steuerbare Umschalter U2 den Rückkopplungszweig. Nach k Takten CLK öffnet der steuerbare Umschalter U2 den Rückkopplungszweig, damit die mittels der Addierer A1 und der Multiplizierer M2 berechneten n - k Paritätssymbole über den steuerbaren Umschalter U3 aus dem rückgekoppelten Schieberegister geschoben werden können. Für die C1-Codierung werden daher ebenso viele Paritätssymbole erzeugt, wie das Schieberegister Stufen hat. Jedes Paritätssymbol ist aus ebensovielen Bits aufgebaut wie ein Datenwort. Die Erzeugung der Paritätssymbole für die C1-Codierung ist damit abgeschlossen.

Zur Erzeugung der Paritätssymbole für die C2-Codierung wird die Hälfte der k Datenworte am Eingang E nacheinander in das rückgekoppelte Schieberegister eingegeben. Anschließend werden die im rückgekoppelten Schieberegister erzeugten n - k Paritätssymbole in das Speicherschieberegister geschoben. Wenn alle n - k Paritätssymbole aus den Registern S1 bis Sn-k des rückgekoppelten Schieberegisters in die Register R1 bis Rn-k des Speicherschieberegisters geschoben sind, gibt eine Steuerschaltung MP, z.B. ein Mikroprozessor, ein Signal L ab, das die steuerbaren Umschalter U1, U2, U3, U4 und U5 umschaltet. Im rückgekoppelten Schieberegister werden daher nun eingelesene Datenworte mit anderen Faktoren multipliziert. Nun wird die zweite Hälfte der k Datenworte am Eingang E eingegeben, und zwar in umgekehrter Reihenfolge. Währenddessen kreisen die Paritätssymbole im Speicherschieberegister in einer geschlossenen Schleife. Nachdem alle k Datenworte den Eingang E passiert haben, wird mit dem Auslesen der berechneten Paritätssymbole begonnen. Im Modulo-2-Addierer A2 werden die n - k Paritätssymbole aus dem rückgekoppelten Schieberegister mit den n - k Paritätssymbolen des Speicherschieberegisters zu neuen n - k Paritätssymbolen verknüpft. Der Modulo-2-Addierer A2 gibt diese neuen n - k Paritätssymbole über den steuerbaren Umschalter U3 an einen nicht eingezeichneten Speicher ab, in dem auch die ursprünglichen k Datenworte gespeichert sind. Im Speicher werden daher ebenso viele Paritätssymbole gespeichert wie ein Schieberegister Stufen hat. Jedes Paritätssymbol besteht aus ebensovielen Bits wie ein Datenwort.

Eine Steuerschaltung liest in einer dem Reed-Solomon-Code entsprechenden Reihenfolge die mittels der beiden Schieberegister erzeugten Paritätssymbole und die ursprünglichen k Datenworte aus dem Speicher, die zeitlich verschachtelt werden. Die auf diese Weise aus dem Speicher ausgelesenen Daten sind jetzt nach dem Reed-Solomon-Code codiert.

Die Erfindung ist zum Aufzeichnen von Daten gemäß dem CD-Standard auf einen Aufzeichnungsträger, z. B. auf eine CD-Platte oder eine magneto-optische Platte, geeignet.

## Patentansprüche

1. Verfahren zur Erzeugung von Paritätssymbolen für Datenworte aus mindestens zwei Bits, bestehend aus folgenden Verfahrensschritten :
a) es werden k erste Datenworte in ein rückgekoppeltes Schieberegister (S1, ..., Sn-k) geschoben
b) das rückgekoppelte Schieberegister (S1, ..., Sn-k) erzeugt aus den k ersten Datenworten ebenso viele Paritätssymbole wie es Stufen hat (n-k), wobei jedes Paritätssymbol ebenso viele Bits hat wie ein Datenwort
c) die vom rückgekoppelten Schieberegister (S1, ..., Sn-k) erzeugten Paritätssymbole werden in ein Speicherschieberegister (R1, ... Rn-k) geschoben
d) in das rückgekoppelte Schieberegister (S1, ..., Sn-k) werden k zweite Datenworte geschoben
e) das rückgekoppelte Schieberegister (S1, ..., Sn-k) erzeugt aus den k zweiten Datenworten ebenso viele Paritätssymbole wie es Stufen hat (n-k), wobei jedes Paritätssymbol aus ebensovielen Bits wie ein Datenwort besteht
f) zum Auslesen der im Speicherschieberegister (R1, ... Rn-k) stehenden Paritätssymbole wird die Richtung des Datensflußes im Speicherschieberegister umgekehrt
g) die im rückgekoppelten Schieberegister und im Speicherschieberegister stehenden Paritätssymbole werden ausgelesen und den Eingängen eines Addierers (A2) zugeführt.
h) der Addierer (A2) erzeugt für die insgesamt zwei k Datenworte aus den vom Speicherschieberegister (R1, ..., Rn-k) und vom rückgekoppelten Schieberegister (S1, ..., Sn-k) gelieferten Paritätssymbole ebenso viele Paritätssymbole wie ein Schieberegister Stufen hat (n-k) , wobei jedes Paritätssymbol aus ebensovielen Bits wie ein Datenwort aufgebaut ist.

2. Verfahren nach Anspruch 1, **dadurch gekennzeichnet**, daß die im rückgekoppelten Schieberegister erzeugten ersten Paritätssymbole mit denen des Speicherschieberegisters in einem Modulo-2-Addierer (A2) verknüpft werden.

3. Schaltungsanordnung zur Durchführung des Verfahrens nach Anspruch 1 oder 2, in welcher zwischen den einzelnen Stufen (S1, ..., Sn-k) des rückgekoppelten Schieberegisters je ein erster Modulo-2-Addierer (A1) vorgesehen ist, wobei dem der letzten Stufe (Sₙ₋ₖ) folgenden ersten Modulo-2-Addierer (A1) an einem zweiten Eingang das Eingangsignal (E) zugeführt wird;
dadurch gekennzeichnet, daß in jedem Rückkopplungszweig, der zum Eingang einer Stufe führt, zwei Multiplizierer (M1, M2) vorgesehen sind, von denen entweder der eine oder der andere mittels eines ersten steuerbaren Umschalters (U1) über einen zweiten Eingang des entsprechenden Modulo-2-Addierers in die Ruckkopplungsschleife geschaltet wird, daß die Rückkopplungsschleife mittels eines zweiten steuerbaren Umschalters (U2) aufgetrennt und geschlossen werden kann, daß der Ausgang der letzten Stufe (Sn-k) mit dem ersten Eingang eines dritten und vierten steuerbaren Umschalters (U3, U4) sowie mit dem ersten Eingang eines zweiten Modulo-2-Addieres (A2) verbunden ist, daß n-k Register (R1, ..., Rn-k) des Speicherschieberegisters derart hintereinander geschaltet sind, daß der Eingang jedes Registers (R2, ..., Rn-k) mit Ausnahme des ersten Registers (R1) mittels je eines fünften steuerbaren Umschalters (U5) entweder mit dem Ausgang des vorhergehenden oder des folgenden Registers verbunden werden kann, so daß der Datenfluß im Speicherschieberegister umkehrbar ist, daß der Eingang des ersten Registers (R1) mittels des vierten steuerbaren Umschalters (U4) entweder mit dem Ausgang des zweiten Registers (R2) des Speicherschieberegisters oder dem Ausgang der letzten Stufe (Sn-k) des rückgekoppelten Schiebsregisters verbunden werden kann, daß der Ausgang des ersten Registers (R1) des Speicherschieberegisters mit dem zweiten Eingang des zweiten Modulo-2-Addierers (A2) verbunden ist, dessen Ausgang mit dem zweiten Eingang des dritten steuerbaren Umschalters (U3) verbunden ist, daß die Steuereingänge der ersten steuerbaren Umschalter (U1), des dritten steuerbaren Umschalters (U3), des vierten steuerbaren Umschalters (U4) und des fünften steuerbaren Umschalters (U5) mit dem ersten Ausgang (L) einer Steuerschaltung (MP) verbunden sind und daß der zweite Ausgang (EN) der Steuerschaltung (MP) mit dem Steuereingang des zweiten steuerbaren Umschalters (U2) vebunden ist.

## Claims

1. A method for the generation of parity symbols for data words comprising at least two bits, consisting of the following method steps:
a) k first data words are shifted into a feedback shift register (S₁...Sn-k),
b) the feedback shift register (S₁...Sn-k) generates from the k first data words as many parity symbols as it has stages (n-k), each parity symbol having as many bits as a data word,
c) the parity symbols generated by the feedback shift register (S₁...Sn-k) are shifted into a shift storage register (R₁...Rn-k),
d) k second data words are shifted into the feedback shift register (S₁...Sn-k),
e) the feedback shift register (S₁-Sn-k) generates from the k second data words as many parity symbols as it has stages (n-k), each parity symbol consisting of as many bits as a data word,
f) the direction of data flow in the shift storage register is reversed to read out the parity symbols held in the shift storage register (R₁.. .Rn-k),
g) the parity symbols held in the feedback shift register and in the shift storage register are read out and fed to the inputs of an adder (A2),
h) the adder (A2) generates for the in total two k data words from the parity symbols supplied by the shift storage register (R₁...Rn-k) and by the feedback shift register (S₁...Sn-k) as many parity symbols as a shift register stage has (n-k), each parity symbol being constructed of as many bits as a data word.

2. A method according to claim 1, characterised in that the first parity symbols generated in the feedback shift register are logically combined in a modulo-2 adder (A2) with those of the shift storage register.

3. A circuit arrangement for performing the method according to claim 1 or 2, in which a respective first modulo-2 adder (A1) is provided between the individual stages (S₁...Sn-k) of the feedback shift register, the input signal (E) being fed to a second input of the first modulo-2 adder (A1) following the last stage (Sn-k); characterised in that in each feedback branch, which leads to the input of a stage, there are provided two multipliers (M1,M2), of which either the one or the other is connected in the feedback loop by means of a first controllable change-over switch (U1) via a second input of the corresponding modulo-2 adder, in that the feedback loop can be opened and closed by means of a second controllable change-over switch (U2), in that the output of the last stage (Sn-k) is connected to the first input of a third and fourth controllable change-over switch (U3,U4) and to the first input of a second modulo-2 adder (A2), in that n-k registers (R1...Rn-k) of the shift storage register are so connected one after the other that the input of each register (R2,...Rn-k) with the exception of the first register (R1) can be connected by means of a respective fifth controllable change-over switch (U5) either to the output of the preceding or the succeeding register so that the data flow in the shift storage register is reversible, in that the input of the first register (R1) can be connected by means of the fourth controllable change-over switch (U4) either to the output of the second register (R2) of the shift storage register or to the output of the last stage (Sn-k) of the feedback shift register, in that the output of the first register (R1) of the shift storage register is connected to the second input of the second modulo-2 adder (A2), the output of which is connected to the second input of the third controllable change-over switch (U3), in that the control inputs of the first controllable change-over switch (U1), the third controllable change-over switch (U3), the fourth controllable change-over switch (U4) and the fifth controllable change-over switch (U5) are connected to the first output (L) of a control circuit (MP) and in that the second output (EN) of the control circuit (MP) is connected to the control input of the second controllable change-over switch (U2).

## Revendications

1. Procédé pour produire des symboles de parité pour des mots de données composés d'au moins deux bits comportant les étapes de procédé suivantes :
a) k premiers mots de données sont décalés dans un registre à décalage rétroactif (S1, ..., Sn-k).
b) Le registre à décalage rétroactif (S1, ..., Sn-k) produit à partir des k premiers mots de données autant de symboles de parité qu'il y a d'étages (n-k), chaque symbole de parité ayant autant de bits qu'un mot de données.
c) Les symboles de parité produits par le registre à décalage rétroactif (S1, ..., Sn-k) sont décalés dans un registre à décalage élément de mémoire (R1, ..., Rn-k).
d) k seconds mots de données sont décalés dans le registre à décalage rétroactif (S1, ..., Sn-k).
e) Le registre à décalage rétroactif (S1, ..., Sn-k) produit à partir des k seconds mots de données autant de symboles de parité qu'il y a d'étages (n-k), chaque symbole de parité ayant autant de bits qu'un mot de données.
f) Pour extraire les symboles de parité qui se trouvent dans le registre à décalage élément de mémoire (R1, ..., Rn-k) le sens du flux de données dans le registre à décalage élément de mémoire est inversé.
g) Les symboles de parité qui se trouvent dans le registre à décalage rétroactif et dans le registre à décalage élément de mémoire sont extraits et amenés aux entrées d'un additionneur (A2).
h) L'additionneur (A2) produit pour les deux k mots de données en tout à partir des symboles de parité fournis par le registre à décalage élément de mémoire (R1, ..., Rn-k) et par le registre à décalage rétroactif (S1, ..., Sn-k) autant de nouveaux symboles de parité qu'un registre à décalage a d'étages (n-k), chaque symbole de parité ayant autant de bits qu'un mot de données.

2. Procédé selon la revendication 1, **caractérisé en ce** que les premiers symboles de parité produits dans le registre à décalage rétroactif sont enchaînés à ceux du registre à décalage élément de mémoire dans un additionneur modulo 2 (A2).

3. Circuit pour exécuter le procédé selon la revendication 1 ou 2 dans lequel un premier additionneur modulo 2 (A1) est respectivement prévu entre les différents étages (S1, ..., Sn-k) du registre à décalage rétroactif, le signal d'entrée (E) étant amené à une seconde entrée au premier additionneur modulo 2 (A1) qui suit le dernier étage (Sn-k); **caractérisé en ce** que deux multiplicateurs (M1, M2) sont prévus dans chaque branche de rétroaction qui conduit à l'entrée d'un étage, multiplicateurs dont l'un ou l'autre est commuté dans la boucle de rétroaction au moyen d'un premier commutateur qui peut être commuté (U1) par une seconde entrée de l'additionneur modulo 2 correspondant, que la boucle de rétroaction peut être ouverte et fermée au moyen d'un second commutateur qui peut être commandé (U2), que la sortie du dernier étage (Sn-k) est reliée à la première entrée d'un troisième et d'un quatrième commutateur qui peut être commandé (U3, U4) ainsi qu'à la première entrée d'un second additionneur modulo 2 (A2), que n-k registres (R1, ..., Rn-k) du registre à décalage élément de mémoire sont commutés en série de telle manière que l'entrée de chaque registre (R2, ..., Rn-k) peut être reliée au moyen d'un cinquième commutateur qui peut être commuté (U5), à l'exception du premier registre (R1), soit à la sortie du registre précédent, soit à la sortie du registre suivant, si bien que le flux de données peut être inversé dans le registre à décalage élément de mémoire, que l'entrée du premier registre (R1) peut être reliée au moyen du quatrième commutateur qui perut être commandé (U4) soit à la sortie du second registre (R2) du registre à décalage élément de mémoire, soit à la sortie du dernier étage (Sn-k) du registre à décalage rétroactif, que la sortie du premier registre (R1) du registre à décalage élément de mémoire est reliée à la seconde entrée du second additionneur modulo 2 (A2) dont la sortie est reliée à la seconde entrée du troisième commutateur qui peut être commandé (U3), que les entrées de commande du premier commutateur qui peut être commandé (U1), du troisième commutateur qui peut être commandé (U3), du quatrième commutateur qui peut être commandé (U4) et du cinquième commutateur qui peut être commandé (U5) sont reliées à la première sortie (L) d'un circuit de commande (MP) et que la seconde sortie (EN) du circuit de commande (MP) est reliée à l'entrée de commande du second commutateur qui peut être commandé (U2).
